Europäisches Patentamt

European Patent Office

Office européen des brevets

(19)

(11) EP 0 435 048 B1

(12) **EUROPÄISCHE PATENTSCHRIFT**

(45) Veröffentlichungstag und Bekanntmachung des
Hinweises auf die Patenterteilung:
**12.03.1997 Patentblatt 1997/11**

(51) Int Cl.⁶: **H03G 3/30**

(21) Anmeldenummer: **90123640.6**

(22) Anmeldetag: **08.12.1990**

(54) **Breitbandverstärkerstufe mit steuerbarer Verstärkung**

Broadband amplifier stage with controllable amplification

Etage d'amplificateur à large bande avec amplification commandable

(84) Benannte Vertragsstaaten:
**BE CH DE FR GB IT LI NL SE**

(30) Priorität: **23.12.1989 DE 3942936**

(43) Veröffentlichungstag der Anmeldung:
**03.07.1991 Patentblatt 1991/27**

(73) Patentinhaber:
• **Alcatel SEL Aktiengesellschaft**
**D-70435 Stuttgart (DE)**
Benannte Vertragsstaaten:
**DE FR IT NL SE**
• **ALCATEL N.V.**
**NL-1077 XX Amsterdam (NL)**
Benannte Vertragsstaaten:
**BE CH GB LI**

(72) Erfinder:
• **Benz, Paul**
**W-7000 Stuttgart 40 (DE)**
• **Lippold, Günther**
**W-7302 Ostfildern 2 (DE)**

(74) Vertreter: **Pohl, Herbert, Dipl.-Ing et al**
**Alcatel Alsthom**
**Intellectual Property Department,**
**Postfach 30 09 29**
**70449 Stuttgart (DE)**

(56) Entgegenhaltungen:
**EP-A- 0 339 529          GB-A- 2 117 583**

• **PATENT ABSTRACTS OF JAPAN vol. 13, no. 097**
**(E-723)7. März 1989 & JP-A- 63 272 114 (NEC ) 9.**
**November 1988**

**Beschreibung**

Die Erfindung betrifft eine Breitbandverstärkerstufe mit steuerbarer Verstärkung nach dem Oberbegriff des Patentanspruchs 1.

In der vorveröffentlichten Patentanmeldung DE 38 14 041 wird eine Breitbandverstärkerstufe beschrieben, deren verstärkendes Element ein erster Feldeffekttransistor ist. Der Drainanschluß des Feldeffekttransistors ist über einen Widerstand mit dem Source-Anschluß eines zweiten Feldeffekttransistors, im folgenden Steuertransistor genannt, verbunden, der den Drainstrom durch den ersten Feldeffekttransistor steuert. Der Source-Anschluß des Steuertransistors liegt für Hochfrequenz über einen Kondensator auf Bezugspotential. Da die Steilheit eines Feldeffekttransistors proportional zur Wurzel aus dem Drainstrom ist, läßt sich durch Steuerung des Drainstromes auch die Verstärkung der Breitbandverstärkerstufe steuern. Die Gate-Vorspannung des Feldeffekttransistors wird aus einem Spannungsteiler gewonnen, der einerseits mit dem Drain-Anschluß des Feldeffekttransistors, andererseits mit einer negativen Spannungsquelle verbunden ist. Vom Teilpunkt wird das Gatepotential über einen Koppelwiderstand auf das Gate des ersten Feldeffekttransistors übertragen. Die Breitbandverstärkerstufe arbeitet nur dann zufriedenstellend, wenn der erste Feldeffekttransistor im Abschnürbereich seines Ausgangskennlinienfeldes betrieben wird. Bei voller Variation der Verstärkung etwa im Verhältnis 1 : 4 ist ein Arbeiten im Abschnürbereich nur dann möglich, wenn die Stromversorgung mit hinreichend großer Betriebsspannung, etwa 12 Volt erfolgt. Für üblicherweise benutzte Betriebsspannungen, wie beispielsweise ±5 Volt, reicht die Eigenverstärkung des Feldeffekttransistors nicht aus, um bei kleinen Strömen ein Arbeiten im Abschnürbereich, d.h. bei fester Drain-Source-Spannung, zu gewährleisten.

Aus dem Patent Abstracts of Japan vol. 13, no. 097 (E-723) ist eine Schaltungsanordnung bekannt, in der mittels einer Rückkopplung mit einem Operationsverstärker der Source-Drain Strom eines Feldeffekttransistors geregelt wird. Der Feldeffekttransistor wird in der beschriebenen Anwendung als steuerbarer Widerstand benutzt.

Aus der Patentanmeldung GB-A-2 117 583 ist des weiteren eine Verstärkerschaltung bekannt, in der eine Temperaturunabhängigkeit der Verstärkung erreicht werden soll. Dazu ist eine Rückkopplung mit einem Operationsverstärker vorgesehen, mittels der der Drain-Strom eines Feldeffekttransistors so geregelt wird, daß er proportional zu einer Steuerspannung ist.

Aufgabe der Erfindung ist es, die Breitbandverstärkerstufe gemäß der DE 38 14 041 so zu verbessern, daß die Drain-Source-Spannung des ersten Feldeffekttransistors auch bei kleinen Strömen konstant bleibt. Diese Aufgabe wird gelöst durch eine Breitbandverstärkerstufe mit der Merkmalskombination des Hauptanspruches. Die Unteransprüche enthalten vorteilhafte Ausgestaltungen der Erfindung.

Die erfindungsgemäße Breitbandverstärkerstufe hat den Vorteil, auch bei üblichen Betriebsspannungen, beispielsweise ± 5 Volt, zufriedenstellend zu arbeiten. Zusätzlich zur Eigenverstärkung des verstärkenden Elementes Feldeffekttransistor ist ein Operationsverstärker mit hoher Verstärkung vorgesehen, der einen konstanten Strom durch den die Gate-Vorspannung erzeugenden Spannungsteiler treibt und auf diese Weise die Drain-Source-Spannung des Feldeffekttransistors konstant hält. Ein weiterer Vorteil der Erfindung liegt darin, daß der Feldeffekttransistor mit seinem Source-Anschluß auf Bezugspotential liegt.

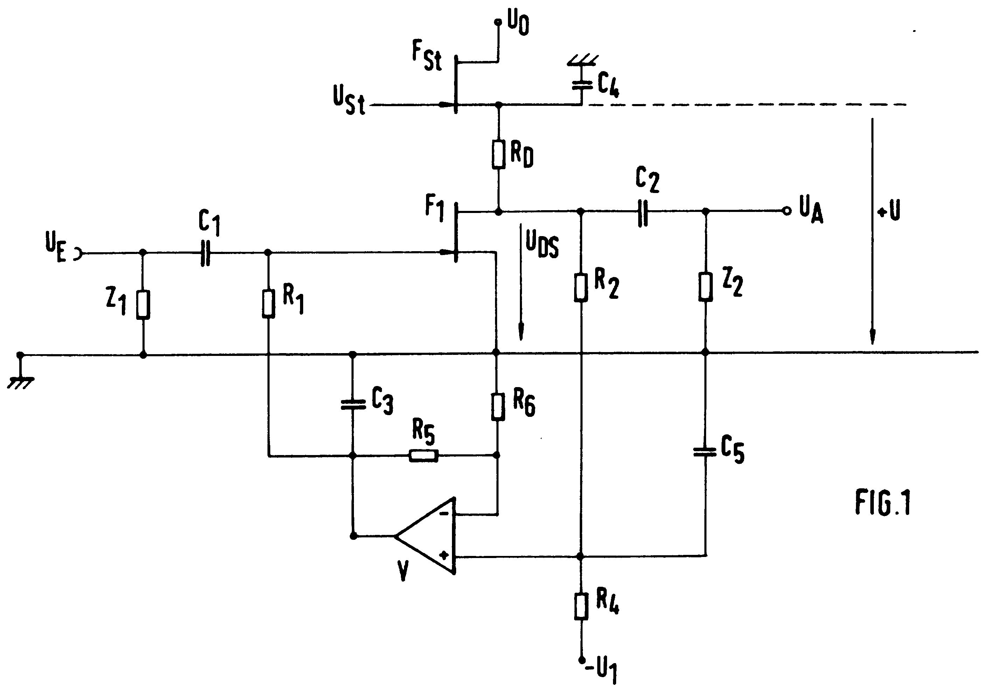

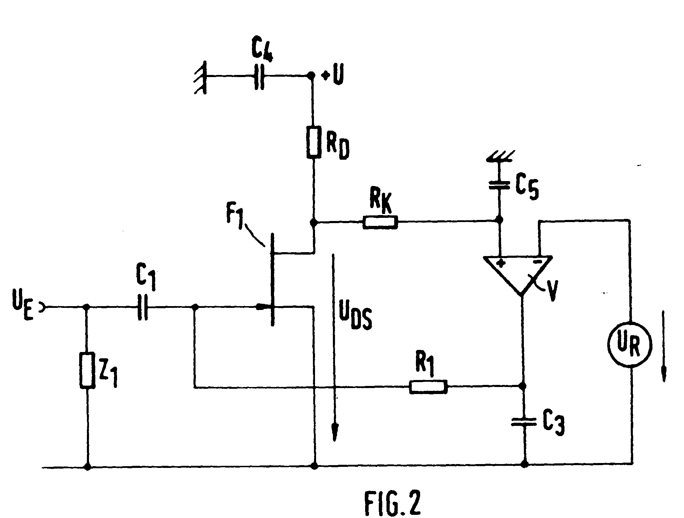

Zwei Ausführungsbeispiele der Erfindung werden anhand der Figuren 1 und 2 beschrieben und näher erläutert. Es zeigen:

Fig. 1    ein Schaltungsbeispiel für die erfindungsgemäße Breitbandverstärkerstufe,

Fig. 2    ein zweites Schaltungsbeispiel für die erfindungsgemäße Breitbandverstärkerstufe.

Mit $F_1$ ist ein Feldeffekttransistor bezeichnet, der eine mit $U_E$ bezeichnete Eingangswechselspannung verstärken soll. Sein Source-Anschluß ist mit dem Bezugspotential verbunden, sein Drain-Anschluß über einen Widerstand $R_D$ mit dem Source-Anschluß eines mit $F_{St}$ bezeichneten Steuertransistors verbunden. Am Gate des Steuertransistors $F_{St}$ liegt eine Steuerspannung $U_{St}$. Der Drainanschluß des Steuertransistors $F_{St}$ ist mit einer Spannungsquelle verbunden, die eine positive Spannung liefert. Der Source-Anschluß des Steuertransistors $F_{St}$ ist über einen Kondensator $C_4$ mit dem Bezugspotential verbunden, liegt also hochfrequenzmäßig auf Bezugspotential. Vom Drain-Anschluß des Transistors $F_1$ führt ein aus zwei Widerständen $R_2$ und $R_4$ bestehendes Spannungsteiler zu einer negativen Spannung $-U_1$. Der Teilpunkt des Spannungsteilers ist über einen mit $C_5$ bezeichneten Kondensator mit dem Bezugspotential verbunden. Gleichzeitig ist er auch mit dem nicht invertierenden Eingang eines Operationsverstärkers V verbunden. Der invertierende Eingang des Verstärkers V ist über zwei mit $R_5$ und $R_6$ bezeichnete Widerstände gegengekoppelt. Der Ausgang des Operationsverstärkers ist außerdem über einen Kondensator $C_3$ mit dem Bezugspotential verbunden. Das Ausgangssignal des Verstärkers V wird über einen mit $R_1$ bezeichneten Widerstand zum Gate des Transistors $F_1$ weitergeleitet. Mit $Z_1$ ist eine Eingangsimpedanz bezeichnet, die der Anpassung einer Eingangsspannungsquelle an den Eingang der Verstärkerstufe dient. Das Gate des Transistors $F_1$ und der Eingang der Verstärkerstufe sind über einen Koppelkondensator $C_1$ gleichstrommäßig entkoppelt. Der Source-Anschluß des Kondensators $F_1$ ist über einen Kondensator $C_2$ mit einer Ausgangsimpedanz $Z_2$ verbunden, an der die verstärkte Eingangsspannung als Ausgangsspannung $U_A$

abgenommen wird.

Die Breitverstärkerstufe arbeitet wie folgt: Das verstärkende Element ist der Feldeffekttransistor $F_1$. Zur Variation der Verstärkung wird der Strom durch den Feldeffekttrransistor $F_1$ gesteuert. Dazu dient der Steuertransistor $F_{St}$. An seinem Drain-Anschluß liegt die positive Gleichspannung $U_O$. Durch Verändern der Spannung am Gate des Transistors $F_{St}$, in der Figur mit $U_{St}$ bezeichnet, wird die über der Reihenschaltung aus dem Widerstand $R_D$ und dem Feldeffekttransistor $F_1$ liegende Spannung $+U$ variiert. Da im Abschnürbereich des Ausgangskennlinienfelds eines Feldeffekttransistors die Spannung $U_{DS}$ größer als 3 V ist und außerdem konstant gehalten werden soll, ändert sich durch diese Maßnahme der Strom durch den Feldeffekttransistor $F_1$. Die für den jeweiligen Betriebspunkt erforderliche Gatespannung wird durch den aus den Widerständen $R_2$ und $R_4$ bestehenden Spannungsteiler eingestellt. Da der Feldeffekttransistor $F_1$ mit einer negativen Vorspannung betrieben werden muß, ist das eine Ende vom Widerstand $R_4$ mit der Spannung $-U_1$ verbunden. In der Schaltung nach dem Stand der Technik wird nun das Potential am Teilpunkt des Spannungsteilers aus den Widerständen $R_2$ und $R_4$ direkt über einen Koppelwiderstand auf das Gate des Feldeffekttransistors $F_1$ übertragen. Die Erfindung besteht darin, zwischen das Gate und den Teilpunkt den Operationsverstärker V zu schalten. Bei kleineren Spannungen von $U_O$ nämlich reicht die Gleichspannungsverstärkung des Feldeffekttransistors $F_1$ nicht mehr aus, um die Drain-Source-Spannung $U_{DS}$ konstant zu halten. Durch Zwischenschalten des Verstärkers V wird die Gesamtverstärkung des Rückkopplungszweiges vergrößert, so daß $U_{DS}$ auch bei Betriebsspannungen $U_O = 5$ Volt konstant gehalten wird. Änderungen $\Delta U$ des Potentials am Teilpunkt des Spannungsteilers werden jetzt mit dem Verstärkungsfaktor A des Operationsverstärkers multipliziert. Für die Gate-Source-Spannung $U_{gs}$ gilt:

$$U_{gs} = - \Delta U \cdot A$$

Da in den Operationsverstärker kein Strom hereinfließt, wird dem Spannungsteiler aus den Widerständen $R_2$ und $R_4$ durch die negative Spannung $-U_1$ ein Strom aufgeprägt, der zu einer Drain-Source-Spannung

$$U_{DS} = \frac{|-U_1|}{R_4} \cdot R_2 = konstant$$

führt.

Für den Drainstrom $I_D$ gilt

$$I_D = \frac{+U_1 - U_{DS}}{R_D} = variabel.$$

Eingangsimpedanz $Z_1$ und Ausgangsimpedanz $Z_2$ sind davon abhängig, für welchen Zweck die Breitbandverstärkerstufe benutzt werden soll. Es können Widerstände sein, die der Anpassung an Leitungen dienen, aber auch solche, die zu einer völligen Fehlanpassung führen. Die Breitbandverstärkerstufe gemäß der Erfindung zeigt eine konstante Verstärkung von 1 kHz bis etwa 2 GHZ. Besonders hervorzuheben ist, daß der Source-Anschluß des Feldeffekttransistors $F_1$ direkt mit dem Bezugspotential verbunden ist. Durch diese Schaltungsmaßnahme wird das Entstehen störender Schwingungen infolge von RC-Gliedern in der Source-Zuleitung verhindert. Auch bei üblichen Betriebsspannungen $U_O$ von $\pm 5$ Volt ist eine Variation der Verstärkung im Verhältnis $1 : 4$ möglich. Es ist nicht zwingend, die Spannung $+U$ mit Hilfe eines Steuertransistors $F_{St}$ einzustellen. Der Vorteil der Verwendung eines Feldeffekttransistors für die Einstellung der Spannung $+U$ liegt darin, daß keine Steuerleistung gebraucht wird. Andere Möglichkeiten für die Steuerung des Drainstroms sind ebenfalls denkbar. So lassen sich anstelle eines Feldeffekttransistors $F_{St}$ beispielsweise auf Bipolartransistoren als gesteuerte Stromquellen verwenden. Wesentlich ist immer, daß die Steuerung der Spannung $+U$ hochfrequenzmäßig mit dem Bezugspotential verbunden ist.

Fig. 2 zeigt ein zweites Ausführungsbeispiel der erfindungsgemäßen Breitbandverstärkerstufe. Gleiche Bezugszeichen bezeichnen die gleichen Elemente wie in Fig. 1 . Dem verstärkenden Element der Verstärkerstufe, dem Feldeffekttransistor $F_1$, wird die Eingangsspannung über den mit $C_1$ bezeichneten Koppelkondensator zugeführt. Wie in Fig. 1 liegt der Source-Anschluß von $F_1$ am Bezugspotential. Die Spannung $+U$ wird über den Widerstand $R_D$ zugeführt. Die Spannung am Drain-Anschluß wird über einen Koppelwiderstand $R_K$ dem nicht invertierenden Eingang des Operationsverstärkers V zugeführt. der nicht invertierende Eingang des Operationsverstärkers ist über den Kondensator $C_5$ auf Bezugspotential gelegt. Am invertierenden Eingang des Operationsverstärkers V liegt eine mit $U_R$ bezeichnete Referenzspannung, die als Sollwert für die Drain-Source-Spannung $U_{DS}$ wirkt. Der Ausgang des operationsverstärkers V ist über den mit $R_1$ bezeichneten Widerstand mit dem Gate-Anschluß von $F_1$ verbunden. Hochfrequenzmäßig liegt er über dem Kondensator $C_3$ auf dem Bezugspotential. Auch in diesem Schaltungsbeispiel werden kleine Änderungen der Drain-Source-Spannung $U_{DS}$ vom Operationsverstärker V verstärkt und führen zu einer Verschiebung des Gatepotentials so, daß sich der ursprüngliche Wert der Drain-Source-Spannung einstellt.

Auf eine Darstellung der Auskopplung des Ausgangssignals wurde verzichtet, da dies für einen mit Breitbandverstärkern befaßten Fachmann eine Selbstverständlichkeit ist.

**Patentansprüche**

1. Breitbandverstärkerstufe mit einem in Source-Schaltung betriebenen Feldeffekttransistor (F1), dessen Verstärkung mittels des ihn durchfließenden Drain-Stromes gesteuert wird, mit einer Vorrichtung, die mit dem Drain-Anschluß des Feldeffekttransistors (F1) verbunden ist, zur Regelung der Drain-Source-Spannung auf einen konstanten Wert, wenn der Feldeffekttransistor (F1) im Abschnürbereich seines Ausgangskennlinienfeldes betrieben wird,

   **dadurch gekennzeichnet**, daß diese Vorrichtung zur Regelung der Drain-Source-Spannung einen Operationsverstärker (V) als Regler zur Regelung der Drain-Source-Spannung auf einen konstanten Wert enthält,

   daß der Ausgang des Operationsverstärkers (V) mit dem Gate des Feldeffekttransistors (F1) verbunden ist, und
   daß der nicht-invertierende Eingang des Operationsverstärkers (V) über einen Widerstand ($R_2$, $R_K$) mit dem Drain-Anschluß des Feldeffekttransistors (F1) verbunden ist.

2. Breitbandverstärkerstufe nach Anspruch 1, gekennzeichnet durch einen von einem konstanten Strom durchflossenen Spannungsteiler ($R_2$, $R_4$) zwischen Drain-Anschluß des Feldeffekttransistors und einer negative Spannungsquelle ($-U_1$).

3. Breitbandverstärkerstufe nach Anspruch 2, dadurch gekennzeichnet, daß der Teilpunkt des Spannungsteilers mit dem nicht-invertierenden Eingang des Operationsverstärkers (V) verbunden ist.

4. Breitbandverstärkerstufe nach Anspruch 1, gekennzeichnet durch eine Gegenkopplung ($R_2$, $R_6$) des Operationsverstärkers.

5. Breitbandverstärkerstufe nach Anspruch 1, dadurch gekennzeichnet, daß ein Transistor ($F_{ST}$) den Drain-Strom des Feldeffekttransistors ($F_1$) steuert.

6. Breitbandverstärkerstufe nach Anspruch 5, dadurch gekennzeichnet, daß der Transistor ($F_{ST}$) hochfrequenzseitig auf Bezugspotential liegt.

7. Breitbandverstärkerstufe nach Anspruch 1, dadurch gekennzeichnet, daß der invertierende Eingang des Operationsverstärkers (V) mit einer Referenzspannungsvorrichtung ($U_R$) verbunden ist.

**Claims**

1. A broadband amplifier stage comprising a field-effect transistor (F1) connected in a common-source configuration, whose gain is controlled by the drain current flowing therethrough, and a device connected to the drain terminal of the field-effect transistor (F1) for regulating the drain-source voltage at a constant value when the field-effect transistor (F1) is being operated in the pinch-off region of its family of output characteristics,

   **characterized in**

   that said device for regulating the drain-source voltage comprises an operational amplifier (V) as a regulator for regulating the drain-source voltage at a constant value,
   that the output of the operational amplifier (V) is connected to the gate of the field-effect transistor (F1), and
   that the noninverting input of the operational amplifier (V) is connected via a resistor ($R_2$, $R_K$) to the drain terminal of the field-effect transistor (F1).

2. A broadband amplifier stage as claimed in claim 1, characterized by a voltage divider ($R_2$, $R_4$) which is connected between the drain terminal of the field-effect transistor and a negative voltage source ($-U_1$), said voltage divider ($R_2$, $R_4$) being traversed by a constant current.

3. A broadband amplifier stage as claimed in claim 2, characterized in that the tap of the voltage divider is connected to the noninverting input of the operational amplifier (V).

4. A broadband amplifier stage as claimed in claim 1, characterized by negative feedback ($R_5$, $R_6$) applied to the operational amplifier.

5. A broadband amplifier stage as claimed in claim 1, characterized in that a transistor ($F_{ST}$) controls the drain current of the field-effect transistor ($F_1$).

6. A broadband amplifier stage as claimed in claim 5, characterized in that the source terminal of the transistor ($F_{ST}$) is grounded to provide a path for radio-frequency current.

7. A broadband amplifier stage as claimed in claim 1, characterized in that the inverting input of the operational amplifier (V) is connected to a reference-voltage device ($U_R$).

**Revendications**

1. Etage amplificateur à large bande comportant un transistor à effet de champ (F1) exploité en drain commun dont l'amplification est commandée au moyen du courant de drain le traversant, comportant un dispositif relié à la borne de drain du transistor à effet de champ (F1) pour régler la tension drain-source à une valeur constante lorsque le transistor à effet de champ (F1) est exploité dans la zone de blocage de son réseau de caractéristiques de sortie, caractérise en ce que ledit dispositif de réglage de La tension drain-source comporte un amplificateur opérationnel (V) comme dispositif de réglage pour régler la tension drain-source à une valeur constante, en ce que la sortie de l'amplificateur opérationnel (V) est reliée à la grille du transistor à effet de champ (F1) et en ce que l'entrée non inverseuse de l'amplificateur opérationnel (V) est relié par une résistance ($R_2$, $R_K$) à la borne de drain du transistor à effet de champ (F1).

2. Etage amplificateur à large bande suivant la revendication 1, caractérisé par un diviseur de tension ($R_2$, $R_4$) traversé par un courant constant, disposé entre la borne de drain du transistor à effet de champ et une source de tension négative ($-U_1$).

3. Etage amplificateur à large bande suivant la revendication 2, caractérisé en ce que le point de division du diviseur de tension est relié à l'entrée non inverseuse de l'amplificateur opérationnel (V).

4. Etage amplificateur à large bande suivant la revendication 1, caractérisé par un contre-couplage ($R_2$, $R_6$) de l'amplificateur opérationnel.

5. Etage amplificateur à large bande suivant la revendication 1, caractérisé en ce qu'un transistor ($F_{ST}$) commande le courant de drain du transistor à effet de champ (F1).

6. Etage amplificateur à large bande suivant la revendication 5, caractérisé en ce que le transistor ($F_{ST}$) est au potentiel de référence, du côté de la haute fréquence.

7. Etage amplificateur à large bande suivant la revendication 1, caractérisé en ce que l'entrée inverseuse de l'amplificateur opérationnel (V) est relié à un dispositif de tension de référence ($U_R$).

FIG.1

FIG.2